# EUROPÄISCHE PATENTSCHRIFT

(11) **EP 2 812 710 B1**
(45) Veröffentlichungstag und Bekanntmachung des Hinweises auf die Patenterteilung: **10.10.2018**
(21) Anmeldenummer: 12715865.7
(22) Anmeldetag: 20.03.2012
(51) Int. Cl.: G01R 19/25

(54) **VERFAHREN UND ANORDNUNG FÜR DIE ERMITTLUNG DER QUALITÄT DER SPANNUNG UND/ODER DES STROMES EINER ENERGIEVERSORGUNGSEINRICHTUNG**
METHOD AND ARRANGEMENT FOR DETERMINING THE QUALITY OF THE VOLTAGE AND/OR CURRENT OF AN ENERGY SUPPLY DEVICE
PROCÉDÉ ET SYSTÈME DE DÉTERMINATION DE LA QUALITÉ DE LA TENSION ET/OU DU COURANT FOURNI PAR UN ÉQUIPEMENT D'ALIMENTATION EN ÉNERGIE

(43) Veröffentlichungstag der Anmeldung: 17.12.2014
(73) Patentinhaber: Siemens Aktiengesellschaft, 80333 München (DE)
(72) Erfinder: SCHRÖDER, Stephan, 90587 Obermichelbach (DE); DESNICA, Sasa, 90475 Nürnberg (DE)
(86) Internationale Anmeldenummer: PCT/EP2012/054901
(87) Internationale Veröffentlichungsnummer: WO 2013/139376

(56) Entgegenhaltungen:
- WO-A1-2007/118436
- US-A1- 2005 273 281
- US-A1- 2008 208 489
- US-A1- 2009 187 344
- US-B1- 6 778 920

## Beschreibung

Die vorliegende Erfindung betrifft ein Verfahren für die Ermittelung der Qualität der Spannung und/oder des Stromes einer Energieversorgungseinrichtung, wobei kontinuierlich Parameter der Spannung und/oder des Stromes erfasst werden und aus den erfassten Parametern die Qualität der Spannung und/oder des Stromes bestimmt wird.

Die Qualität der Spannung und/oder des Stromes wird häufig auch als Power Quality bezeichnet. Eine Energieversorgungseinrichtung kann z.B. ein Stromnetz oder ein Stromnetzabzweig sein, welcher industrielle und/oder private Kunden mit Elektrizität beliefert.

Die Qualität der Spannung und/oder des Stromes kann anhand einer Reihe von verschiedenen Parametern bestimmt werden. So können beispielsweise als Parameter die Anzahl von Spannungs- oder Stromabbrüchen, die Abweichungen der Frequenz oder der Spannungshöhe von vorgegebenen Werten, die Verletzung des Oberschwingungsanteils, die Gesamte Harmonische Verzerrung (auch bekannt als total harmonic distorsion) oder Flicker erfasst werden.

Bei einem bekannten Verfahren dieser Art (Norm IEC 61000-4-30:2008) sind Messvorschriften für die Ermittelung der Qualität der Spannung und/oder des Stromes einer Energieversorgungseinrichtung beschrieben. Gemäß dieser Norm kann ein sogenanntes Flagging vorgenommen werden, bei dem die Messdaten für alle Parameter gekennzeichnet werden, nachdem ein Parameter einen vorher festgesetzten Grenzwert verletzt hat. Eine Grenzwertverletzung tritt beispielsweise bei einem Spannungsabfall auf. Die gekennzeichneten Parameter können in der Auswertung der Qualität der Spannung und/oder des Stromes nach Bedarf verwendet werden oder auch von der Auswertung ausgeschlossen werden.

Die Europäische Patentschrift EP0829125B1 beschreibt ein Verfahren zum Messen elektrischer Energie. Bleibt die gemessene Spannung für eine vorgegebene Zeit unterhalb eines Grenzwerts, so wird die Grenzwertverletzung aufgezeichnet. Es erfolgt außerdem eine Benachrichtigung des Energieversorgers oder des Verbrauchers.

Ferner ist aus der Patentschrift US 2009/187344 A1 ein gattungsgemäßes Verfahren bekannt.

Es ist die Aufgabe der Erfindung, ein Verfahren für die Ermittelung der Qualität einer Spannung und/oder eines Stromes einer Energieversorgungseinrichtung zur Verfügung zu stellen, mit dem die Ermittelung der Qualität einer Spannung und/oder eines Stromes einer Energieversorgungseinrichtung erleichtert wird.

Zur Lösung der Aufgabe schlägt die Erfindung das Verfahren nach Anspruch 1 vor, in dem bewusst vorgenommene Abschaltungen der Energieversorgungseinrichtung erfasst werden und während der Dauer der Abschaltungen erfasste Parameter gekennzeichnet werden. Unter bewusst vorgenommenen Abschaltungen werden dabei vom Betriebspersonal ausgelöste, vorher geplante Abschaltungen von Teilen eines Energieversorgungsnetzwerkes oder eines gesamten Energieversorgungsnetzwerks verstanden. Eine bewusst vorgenommene Abschaltung kann beispielsweise wegen geplanter Wartungsarbeiten an einzelnen Anlagen innerhalb des Energieversorgungsnetzwerks vorgenommen werden. Die Dauer der bewusst vorgenommenen Abschaltung ist der Zeitraum vom Trennen der leitenden Verbindung bis zum Wiederzuschalten der leitenden Verbindung. Das erfindungsgemäße Verfahren hat gegenüber dem Stand der Technik den Vorteil, dass während bewusst vorgenommener Abschaltungen alle kontinuierlich erfassten Parameter der Spannung und/oder des Stromes besonders gekennzeichnet werden und daher in den Aufzeichnungen der erfassten Parameter von anderen Störungen leicht unterscheidbar sind. Auf diese Weise können die während bewusst vorgenommener Abschaltungen erfassten Parameter von einer weiteren Auswertung zur Bestimmung der Qualität der Spannung und/oder des Stromes ausgeschlossen werden. Die Auswertung der erfassten Parameter ist somit aufschlussreicher im Hinblick auf tatsächliche Störungen. Das Bestimmen der Qualität der Spannung und/oder des Stromes lässt sich auf diese Weise zielgerichteter als beim Stand der Technik vornehmen.

In einer bevorzugten Ausführungsform des erfindungsgemäßen Verfahrens wird bei einer Energieversorgungseinrichtung ein Trenner verwendet; die bewusst vorgenommenen Abschaltungen werden mittels einer Erkennung der Stellung des Trenners erfasst. Diese Ausführungsform hat den Vorteil, bewusst vorgenommene Abschaltungen eindeutig und zuverlässig zu erkennen. Trenner können Vorrichtungen für die Übermittelung der Trennerstellung aufweisen.

In einer Weiterbildung der vorgenannten Ausführungsform ergibt sich die Dauer der bewusst vorgenommenen Abschaltungen aus der Zeit zwischen einem Startzeitpunkt und einem Endzeitpunkt; der Startzeitpunkt ist der Zeitpunkt der Öffnung des Trenners minus einer Toleranzzeitspanne und der Endzeitpunkt ist der Zeitpunkt des Schließens des Trenners plus der Toleranzzeitspanne. Beim Öffnen und Schließen eines Trenners kommt es nämlich häufig vor, dass die erfassten Parameter für eine gewisse Zeit verfälscht werden. Eine solche Verfälschung kann sich beispielsweise daraus ergeben, dass die erfassten Parameter als Mittelwerte über einen bestimmten Zeitraum erfasst werden. Diese Ausführungsform hat daher den Vorteil, dass verfälschte Parametermessungen durch die Anwendung einer Toleranzzeit gekennzeichnet werden und somit von einer späteren Auswertung ausgeschlossen werden können.

In einer anderen Ausführungsform des erfindungsgemäßen Verfahrens werden zur Erkennung der bewusst vorgenommenen Abschaltungen Grenzwertverletzungen der Spannung und/oder des Stromes der Energieversorgungseinrichtung erfasst. Bei einer eine vorgegebene Zeitdauer überschreitenden Dauer der Grenzwertverletzung werden die erfassten Parameter besonders gekennzeichnet. Das vorgenannte Verfahren hat den Vorteil, dass bewusst vorgenommene Abschaltungen der Energieversorgungseinrichtung bzw. Unterbrechungen der leitenden Verbindung zu der Energieversorgungseinrichtung direkt anhand der erfassten Parameter festgestellt und in den Messdaten gekennzeichnet werden können. Auf diese Weise wird an dem Trenner keine Stellungserfassung benötigt, um die Trennerstellung an eine zentrale Datenauswertungsanordnung zu übermitteln.

In einer weiteren Ausführungsform des erfindungsgemäßen Verfahrens ist es vorteilhaft, wenn die vorgegebene Zeitdauer mindestens eine Stunde, vorzugsweise mindestens zwei Stunden und besonders bevorzugt mindestens fünf Stunden beträgt. Eine vorgegebene Zeitdauer von im Bereich über einer Stunde ist vorteilhaft, weil bewusst vorgenommen Abschaltungen, beispielsweise für Wartungsarbeiten, oft mehrere Stunden dauern.

In einer anderen Ausführungsform des erfindungsgemäßen Verfahrens weist die Energieversorgungseinrichtung eine Sollspannung auf. Die Grenzwertverletzungen der Spannung werden bei einer Unterschreitung der Sollspannung um mehr als 95 %, insbesondere mehr als 99 %, erfasst. Eine Grenzwertverletzung mehr als 95 %, also ein Rückgang der Spannung auf weniger als 5%, ist ein vorteilhafter Wert, weil ein solcher Rückgang in der Energietechnik als charakteristisch für den Ausfall einer Leitung angesehen wird.

In einer weiteren vorteilhaften Ausführungsform des erfindungsgemäßen Verfahrens erfolgt die Kennzeichnung der erfassten Parameter direkt in den aufgenommenen Messdaten mittels einer computerlesbaren Ergänzung. Die computerlesbare Ergänzung kann dann bei einer rechnergestützten Auswertung der Qualität der Spannung und/oder des Stromes ohne weitere Zwischenschritte verwendet werden, um beispielsweise automatisiert die besonders gekennzeichneten Parameter bei der Ermittlung der Qualität der Spannung und/oder des Stromes der Energieversorgungseinrichtung unberücksichtigt zu lassen.

In einer anderen bevorzugten Ausführungsform des erfindungsgemäßen Verfahrens erfolgt die Kennzeichnung der erfassten Parameter mittels einer farblichen Hervorhebung. Eine solche farbliche Hervorhebung kann bei jeder denkbaren Visualisierung der erfassten Parameter erfolgen, also beispielsweise als rote Linie bei einer Ausgabe des zeitlichen Verlaufs der erfassten Parameter auf Papier oder einem Bildschirm. Eine farbliche Hervorhebung kann aber auch durch andersfarbige Symbole erfolgen. Die farbliche Hervorhebung ist vorteilhaft, weil sie es besonders leicht erkennbar macht, wann bewusst vorgenommene Abschaltungen erfolgt sind.

In dem erfindungsgemäßen Verfahren bleiben die besonders gekennzeichneten Parameter bei der Ermittelung der Qualität der Spannung und/oder des Stromes der Energieversorgungseinrichtung unberücksichtigt. Dieses Vorgehen, die während einer bewusst vorgenommenen Abschaltung erfassten Parameter nicht in die Auswertung mit einzubeziehen, ist von Vorteil, weil es dadurch vermieden wird, verfälschte Schlüsse zur Qualität der Spannung und des Stromes zu ziehen. Vielmehr werden nur vom Betrieb des Energieversorgungsnetzes herrührende Störungen berücksichtigt.

Die Erfindung betrifft ferner eine Anordnung für die Ermittelung der Qualität der Spannung und/oder des Stromes einer Energieversorgungseinrichtung nach Anspruch 8, wobei mit der Anordnung kontinuierlich Parameter der Spannung und/oder des Stromes erfasst werden und aus den erfassten Parametern die Qualität der Spannung und/oder des Stromes bestimmt wird.

Zur Lösung der Aufgabe, die Ermittelung der Qualität einer Spannung und/oder eines Stromes einer Energieversorgungseinrichtung zu erleichtern, weist die Anordnung erfindungsgemäß eine Erkennungseinheit auf, mit der bewusst vorgenommene Abschaltungen der Energieversorgungseinrichtung erfasst werden; außerdem ist eine Kennzeichnungseinheit vorgesehen, in der während der Dauer der Abschaltungen erfasste Parameter besonders gekennzeichnet werden.

Der wesentliche Vorteil der erfindungsgemäßen Anordnung besteht darin, dass es mittels einer Erkennungseinheit und einer Kennzeichnungseinheit möglich ist, während bewusst vorgenommener Abschaltungen erfasste Parameter besonders zu kennzeichnen.

In einer vorteilhaften Ausführungsform der erfindungsgemäßen Anordnung steht bei einer Energieversorgungseinrichtung mit einem Trenner die Erkennungseinheit mit dem Trenner in Verbindung. Eine Verbindung kann beispielsweise ein Datenübertragungskanal sein. Unter einem Datenübertragungskanal wird dabei jede Art von leitungsgebundener Kommunikationsverbindung oder drahtloser Kommunikationsverbindung verstanden. Der Trenner kann auf diese Weise Informationen über die Stellung seiner Schalteinrichtung an die Erkennungseinheit der erfindungsgemäßen Anordnung übermitteln.

In einer anderen Ausführungsform der erfindungsgemäßen Anordnung ist der Kennzeichnungseinheit eine Grenzwertstufe vorgeordnet; bei bewusst vorgenommenen Abschaltungen stellt die Grenzwertstufe Grenzwertverletzungen der Spannung und/oder des Stromes der Energieversorgungseinrichtung fest. Liegt eine Grenzwertverletzung mit einer eine vorgegebene Zeitdauer überschreitenden Dauer vor, so gibt die Grenzwertstufe ein Steuersignal an die Kennzeichnungseinheit ab. Die Kennzeichnungseinheit kann anhand des Steuersignals die aufgezeichneten erfassten Parameter der Spannung und/oder des Stromes als zu einer bewusst vorgenommenen Abschaltung zugehörig besonders kennzeichnen.

In einer Weiterbildung der vorgenannten Ausführungsform der erfindungsgemäßen Anordnung ist es vorteilhaft, wenn die vorgegebene Zeitdauer mindestens eine Stunde, vorzugsweise mindestens zwei Stunden und besonders bevorzugt mindestens fünf Stunden beträgt. Eine vorgegebene Zeitdauer von im Bereich über einer Stunde ist vorteilhaft, weil bewusst vorgenommen Abschaltungen, beispielsweise für Wartungsarbeiten, oft mehrere Stunden dauern.

In einer anderen Ausführungsform der erfindungsgemäßen Anordnung weist die Energieversorgungseinrichtung eine Sollspannung auf. Die Grenzwertverletzungen der Spannung werden bei einer Unterschreitung der Sollspannung um mehr als 95 %, insbesondere mehr als 99 %, erfasst. Eine Grenzwertverletzung mehr als 95 %, also ein Rückgang der Spannung auf weniger als 5%, ist ein vorteilhafter Wert, weil ein solcher Rückgang in der Energietechnik als charakteristisch für den Ausfall einer Leitung angesehen wird.

Die erfindungsgemäße Anordnung weist eine Auswertestufe auf, die die besonders gekennzeichneten Parameter bei der Ermittlung der Qualität der Spannung und/oder des Stromes der Energieversorgungseinrichtung ausschließt. Das Ausschließen der besonders gekennzeichneten Parameter ist besonders vorteilhaft, weil es dadurch vermieden wird, verfälschte Schlüsse über die Qualität der Spannung und des Stromes zu ziehen. Vielmehr werden nur vom Betrieb des Energieversorgungsnetzes herrührende Störungen von der Anordnung berücksichtigt.

Zur weiteren Erläuterung des erfindungsgemäßen Verfahrens sind in
- Figur 1: ein zeitabhängiger Verlauf von verschiedenen Parametern der Spannung im Falle einer bewussten Abschaltung der Energieversorgungseinrichtung, in
- Figur 2: der zeitliche Verlauf des Effektivwertes der Spannung an dem Stromnetzabzweig mit einer bewusst vorgenommenen Abschaltung und in
- Figur 3: in schematischer Weise ein Stromnetzabzweig
gezeigt.

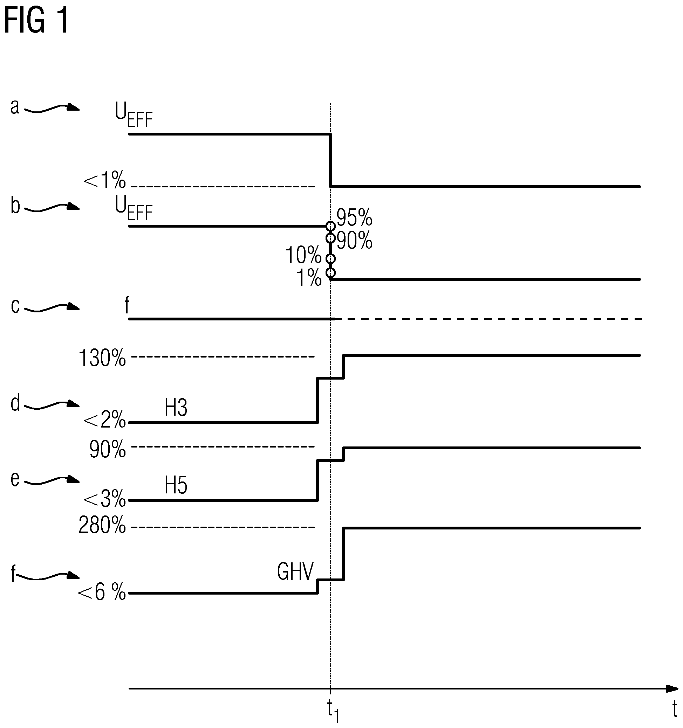

In der Figur 1 ist in Diagramm a der zeitabhängige Verlauf einer Spannung U_{EFF} im Falle einer bewusst vorgenommenen Abschaltung einer Energieversorgungseinrichtung dargestellt.

Zum Zeitpunkt t₁ der bewusst vorgenommenen Abschaltung der Energieversorgungseinrichtung bricht die Spannung U von in etwa 100% der vorgesehen Spannung der Energieversorgungseinrichtung auf im Rahmen der Messungenauigkeit unter 1% ein. Wird die Spannung U dabei mit einer hohen zeitlichen Auflösung gemessen, so können bei ihrem Abfall Messpunkte nicht nur bei 100% und 0%, sondern auch bei beispielsweise 95%, 90% und 10% erfasst werden, wie es im Diagramm b schematisch dargestellt ist.

Die Frequenz f der Spannung U ist ebenfalls ein Parameter, der erfasst wird. Wie dem Diagramm c zu entnehmen ist, kann ab dem Zeitpunkt t₁ der bewusst vorgenommenen Abschaltung die Frequenz f (beispielsweise 50 Hz) nicht weiter gemessen werden (dargestellt durch eine gestrichelte Linie).

Aus dem Diagramm d geht hervor, dass die dritte Harmonische H3 der Spannung U als ein weiterer Parameter zum Zeitpunkt t₁ der bewusst vorgenommenen Abschaltung von unter 2% auf 130% ansteigt. Dies erklärt sich dadurch, dass die dritte Harmonische H3 relativ zur Grundschwingung der Spannung U ermittelt wird. Da die Grundschwingung im Falle einer bewusst vorgenommenen Abschaltung stark abfällt, kann es vorkommen, dass die dritte Harmonische H3 einen Wert von über 100% der Grundschwingung annimmt. In gleicher Weise kann es vorkommen, dass, wie es Diagramme zeigt, die fünfte Harmonische H5 als zusätzlicher Parameter von einem Wert von unter 3% auf bis zu 90% der Grundschwingung ansteigt. Auch die gesamte harmonische Verzerrung GHV, die sich auf die Gesamtheit aller Harmonischen bezieht, kann im Falle der bewusst vorgenommenen Abschaltung von unter 6% auf bis zu 280% der Grundschwingung der Spannung U ansteigen. (vgl. Diagramm f).

Wie in der Figur 1 klar zu erkennen ist, werden die erfassten Parameter der Spannung U im Falle einer bewussten Abschaltung durch den Abschaltungsvorgang verändert. Die auf diese Weise veränderten Parameter der Spannung U dürfen zur Ermittlung der Qualität der Spannung oder des Stromes nicht herangezogen werden, sondern müssen unberücksichtigt bleiben.

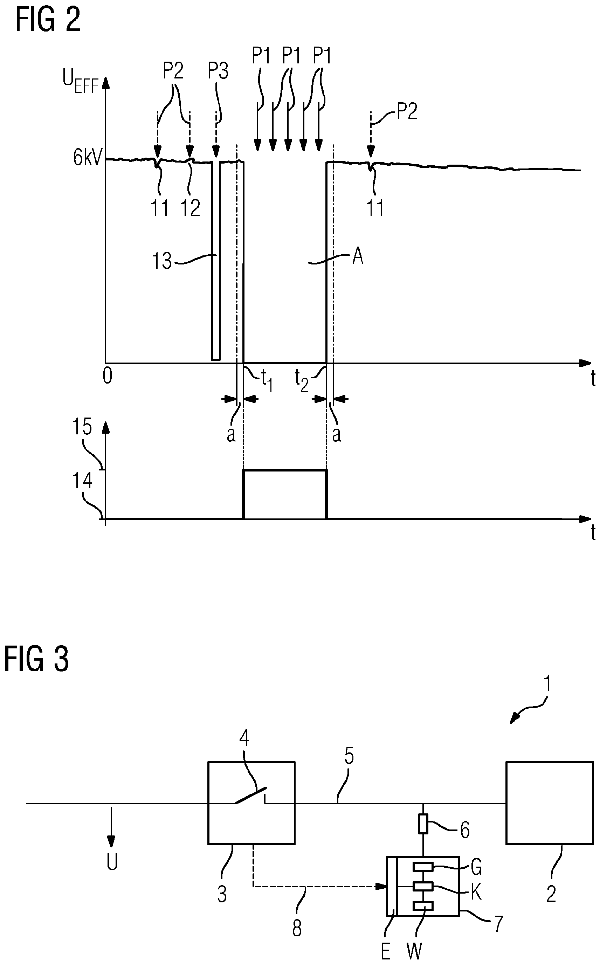

Figur 2 zeigt das Kennzeichnen eines Parameters der Spannung, beispielsweise des Parameters Effektivspannung U_{EFF} (z.B. 6 kV), während einer bewusst vorgenommenen Abschaltung A im Zeitraum von t₁ bis t₂. Diese Kennzeichnung ist insofern besonders, als sie mittels durchgezogener Pfeile P1 erfolgt. Kurze Abfälle 11 ebenso wie kurze Anstiege 12 des Parameters Effektivspannung U_{EFF} sind in den Messdaten durch gestrichelte Pfeile P2 markiert. Ein kurzzeitiger Ausfall 13 der Spannung, der jedoch nicht bewusst herbeigeführt wurde, ist mit Pfeilen P₃ markiert. Zum Zeitpunkt t₁ wird der Trenner in eine offene Position 15 und zum Zeitpunkt t₂ wieder in eine geschlossene Position 14 geschaltet. In dieser Figur bleibt die Stellung eines dem Trenner beigeordneten Leistungschalters unberücksichtigt. Es wird vielmehr davon ausgegangen, dass der Öffnung des Leistungsschalters rasch die Öffnung des Trenners folgt. Ebenso wird davon ausgegangen, dass dem Schließen des Trenners rasch das Schließen des Leistungsschalters folgt.

Die bewusst vorgenommene Abschaltung A wird in den Messdaten für die Effektivspannung also mittels der durchgezogenen Pfeile P1 besonders gekennzeichnet. Hierdurch wird die Bestimmung der Qualität der Spannung und gegebenenfalls des Stromes erleichtert. Dabei kann die Kennzeichnung mittels der Toleranzzeitspanne a auf die Messdaten kurz vor der Abschaltung und kurz nach der Zuschaltung ausgedehnt werden, um Übergangseffekte in dem erfassten Parameter U_{EFF} gleichfalls kenntlich zu machen. Werden außer der Effektivspannung noch weitere Parameter der Spannung oder des Stromes erfasst, so werden auch diese entsprechend gekennzeichnet.

Auf diese Weise ist es für die Auswertung der Qualität der Effektivspannung und anderer Parameter überhaupt erst möglich, anhand der aufgezeichneten Messdaten zwischen betriebsbedingten Störungen der Spannung, wie z.B. kurzen Abfällen 11 und kurzen Anstiegen 12 der Effektivspannung U_{EFF}, und bewusst vorgenommenen Abschaltungen A zu unterscheiden.

In der Figur 3 ist ein Beispiel für den technischen Aufbau eines Stromnetzabzweigs 1 eines nicht weiter gezeigten Energieversorgungsnetzes dargestellt, bei dem das erfindungsgemäße Verfahren eingesetzt werden kann, um bei einem Verbraucher 2 die Qualität der Spannung U und/oder des Stromes zu ermitteln. Der Stromnetzabzweig 1 weist eingangsseitig einen Trenner 3 auf, welcher eine Schalteinrichtung 4 besitzt. Der Trenner 3 ist mittels einer Leitung 5 mit dem Verbraucher 2 verbunden. An der Leitung 5 befindet sich ein Spannungswandler 6, an dem sekundärseitig eine die Parameter der Spannung erfassende Anordnung 7 angeschlossen ist.

Der Spannungswandler 6 ist dafür geeignet, die Spannung U des Stromnetzabzweigs 1 so zu transformieren, dass eine Erfassung von Parametern der Spannung in der Anordnung 7 möglich ist. Der Trenner 3 übermittelt außerdem Informationen über die Stellung seiner Schalteinrichtung 4 mittels eines Datenübertragungskanals 8 an die Anordnung 7. Bei der Anordnung 7 handelt es sich um ein Gerät zur Ermittelung der Qualität der Spannung U. In der dargestellten Ausführungsform übermittelt der Trenner 3 die Information, dass die Leitung 5 von dem Energieversorgungsnetz getrennt ist, an die Anordnung 7. In der Anordnung 7 ist eine Erkennungseinheit E vorgesehen, die anhand der Stellung des Trenners 3 bewusst vorgenommene Abschaltungen erkennt. Die Erkennungseinheit E übermittelt die Information, dass eine bewusst vorgenommene Abschaltung vorliegt, innerhalb der Anordnung 7 an eine Kennzeichnungseinheit K. Die Kennzeichnungseinheit K fügt den erfassten Parametern der Spannung U und/oder des Stromes eine besondere Kennzeichnung hinzu, die die erfassten Parameter als einer bewusst vorgenommenen Abschaltung zugehörig markiert.

In einer Weiterbildung der erfindungsgemäßen Anordnung 7 ist alternativ oder zusätzlich zu der Erkennungseinheit E eine Grenzwertstufe G vorgesehen. Die Grenzwertstufe G überwacht die erfassten Parameter der Spannung oder des Stromes auf Grenzwertverletzungen, die eine bestimmte vorgegebene Dauer überschreiten. Bei Grenzwertverletzungen und Zeitdauerüberschreitungen übermittelt die Grenzwertstufe G ein Steuersignal an die Kennzeichnungseinheit K, so dass die Kennzeichnungseinheit K den erfassten Parametern der Spannung und/oder des Stromes eine besondere Kennzeichnung hinzufügt, welche die erfassten Parameter als einer bewusst vorgenommenen Abschaltung zugehörig markiert.

Anschließend werden in einer in der Anordnung 7 vorgesehenen Auswertestufe W die besonders gekennzeichnete Parameter von der Auswertung der Qualität der Spannung U und/oder des Stromes ausgeschlossen.

## Patentansprüche

1. Verfahren für die Ermittlung der Qualität der Spannung (U) und/oder des Stromes einer Energieversorgungseinrichtung, wobei kontinuierlich Parameter der Spannung (U_{EFF}, f, H3, H5, GHV) und/oder des Stromes erfasst und aus den erfassten Parametern (U_{EFF}, f, H3, H5, GHV) die Qualität der Spannung und/oder des Stromes bestimmt wird, und wobei vorher geplante Abschaltungen (A) der Energieversorgungseinrichtung erfasst werden und während der Dauer der Abschaltungen erfasste Parameter (U_{EFF}, f, H3, H5, GHV) besonders gekennzeichnet werden,
**dadurch gekennzeichnet, dass**
die besonders gekennzeichneten Parameter (U_{EFF}, f, H3, H5, GHV) bei der Ermittlung der Qualität der Spannung und/oder des Stromes der Energieversorgungseinrichtung unberücksichtigt bleiben.

2. Verfahren nach Anspruch 1,
**dadurch gekennzeichnet, dass**
bei einer Energieversorgungseinrichtung mit einem Trenner (3) die vorher geplanten Abschaltungen (A) mittels einer Erkennung der Stellung des Trenners (3) erfasst werden.

3. Verfahren nach Anspruch 2,
**dadurch gekennzeichnet, dass**
sich die Dauer der vorher geplanten Abschaltungen (A) aus der Zeit zwischen einem Startzeitpunkt (t₁) und einem Endzeitpunkt (t₂) ergibt, wobei der Startzeitpunkt (t₁) der Zeitpunkt der Öffnung des Trenners (3) minus einer Toleranzzeitspanne (a) ist und wobei der Endzeitpunkt (t₂) der Zeitpunkt des Schließens des Trenners (3) plus der Toleranzzeitspanne (a) ist.

4. Verfahren nach einem der vorhergehenden Ansprüche,
**dadurch gekennzeichnet, dass**
zur Erkennung der vorher geplanten Abschaltungen (A) Grenzwertverletzungen der Spannung (U) und/oder des Stromes der Energieversorgungseinrichtung erfasst werden und bei einer eine vorgegebene Zeitdauer überschreitenden Dauer der Grenzwertverletzung die erfassten Parameter (U_{EFF}, f, H3, H5, GHV) gekennzeichnet werden.

5. Verfahren nach Anspruch 4,
**dadurch gekennzeichnet, dass**
die vorgegebene Zeitdauer mindestens eine Stunde, vorzugsweise mindestens zwei Stunden und besonders bevorzugt mindestens fünf Stunden beträgt.

6. Verfahren nach Anspruch 4 oder 5,
**dadurch gekennzeichnet, dass**
bei einer Energieversorgungseinrichtung mit einer Sollspannung die Grenzwertverletzungen der Spannung (U) bei einer Unterschreitung der Sollspannung um mehr als 95%, insbesondere mehr als 99%, erfasst werden.

7. Verfahren nach einem der vorhergehenden Ansprüche,
**dadurch gekennzeichnet, dass**
die Kennzeichnung der erfassten Parameter (U_{EFF}, f, H3, H5, GHV) direkt in den aufgenommenen Messdaten mittels einer computerlesbaren Ergänzung erfolgt.

8. Anordnung (7) für die Ermittelung der Qualität der Spannung (U) und/oder des Stromes einer Energieversorgungseinrichtung, wobei die Anordnung (7) dazu eingerichtet ist, kontinuierlich Parameter der Spannung (U_{EFF}, f, H3, H5, GHV) und/oder des Stromes zu erfassen und aus den erfassten Parametern (U_{EFF}, f, H3, H5, GHV) die Qualität der Spannung (U) und/oder des Stromes zu bestimmen, wobei eine Erkennungseinheit (E) vorgesehen ist, die dazu eingerichtet ist, vorher geplante Abschaltungen (A) der Energieversorgungseinrichtung zu erfassen, und wobei eine Kennzeichnungseinheit (K) vorgesehen ist, die dazu eingerichtet ist, während der Dauer der Abschaltungen (A) erfasste Parameter (U_{EFF}, f, H3, H5, GHV) besonders zu kennzeichnen, **gekennzeichnet durch**
eine Auswertestufe (W), die dazu eingerichtet ist, die besonders gekennzeichneten Parameter (U_{EFF}, f, H3, H5, GHV) bei der Ermittelung der Qualität der Spannung (U) und/oder des Stromes der Energieversorgungseinrichtung auszuschließen.

9. Anordnung (7) nach Anspruch 8,
**dadurch gekennzeichnet, dass**
bei einer Energieversorgungseinrichtung mit einem Trenner (3) die Erkennungseinheit (E) mit dem Trenner (3) in Verbindung steht.

10. Anordnung (7) nach einem der Ansprüche 8 oder 9,
**dadurch gekennzeichnet, dass**
der Kennzeichnungseinheit (K) eine Grenzwertstufe (G) vorgeordnet ist, die dazu eingerichtet ist, bei vorher geplanten Abschaltungen (A) Grenzwertverletzungen der Spannung (U) und/oder des Stromes der Energieversorgungseinrichtung festzustellen und bei einer Grenzwertverletzungen mit einer eine vorgegebene Zeitdauer überschreitenden Dauer ein Steuersignal an die Kennzeichnungseinheit (K) abzugeben.

11. Anordnung (7) nach Anspruch 10,
**dadurch gekennzeichnet, dass**
die vorgegebene Zeitdauer mindestens eine Stunde, vorzugsweise mindestens zwei Stunden und besonders bevorzugt mindestens fünf Stunden beträgt.

12. Anordnung (7) nach einem der Ansprüche 10 oder 11,
**dadurch gekennzeichnet, dass**
bei einer Energieversorgungseinrichtung mit einer Sollspannung die Grenzwertverletzungen der Spannung (U) bei einer Unterschreitung der Sollspannung um mehr als 95 %, insbesondere mehr als 99 %, erfasst werden.

## Claims

1. Method for determining the quality of the voltage (U) and/or current of an energy supply device, wherein parameters of the voltage (U_{RMS}, f, H3, H5, THD) and/or current are continuously detected and the quality of the voltage and/or current is determined from the detected parameters (U_{RMS}, f, H3, H5, THD), and wherein preplanned disconnections (A) of the energy supply device are detected and parameters (U_{RMS}, f, H3, H5, THD) detected over the duration of the disconnections are explicitly flagged,
**characterised in that**
the explicitly flagged parameters (U_{RMS}, f, H3, H5, THD) remain out of consideration during the determination of the quality of the voltage and/or current of the energy supply device.

2. Method according to claim 1,
**characterised in that**
in the case of an energy supply device having an isolator (3) the preplanned disconnections (A) are detected by means of a recognition of the setting of the isolator (3).

3. Method according to claim 2,
**characterised in that**
the duration of the preplanned disconnections (A) is yielded from the time between a start time instant (t₁) and an end time instant (t₂), wherein the start time instant (t₁) is the time instant of the opening of the isolator (3) minus a tolerance time interval (a) and wherein the end time instant (t₂) is the time instant of the closing of the isolator (3) plus the tolerance time interval (a).

4. Method according to one of the preceding claims,
**characterised in that**
in order to detect the preplanned disconnections (A) threshold value violations of the voltage (U) and/or current of the energy supply device are detected and if a duration of the threshold value violation exceeds a predefined time period the detected parameters (U_{RMS}, f, H3, H5, THD) are flagged.

5. Method according to claim 4,
**characterised in that**
the predefined time period amounts to at least one hour, preferably at least two hours, and particularly preferably at least five hours.

6. Method according to claim 4 or 5,
**characterised in that**
in the case of an energy supply device having a nominal voltage the threshold value violations of the voltage (U) are detected in the event of the nominal voltage being undershot by more than 95%, in particular more than 99%.

7. Method according to one of the preceding claims,
**characterised in that**
the detected parameters (U_{RMS}, f, H3, H5, THD) are flagged directly in the recorded measurement data by means of a computer-readable extension.

8. Arrangement (7) for determining the quality of the voltage (U) and/or current of an energy supply device, wherein the arrangement (7) is configured to continuously detect parameters of the voltage (U_{RMS}, f, H3, H5, THD) and/or current and to determine the quality of the voltage (U) and/or current from the detected parameters (U_{RMS}, f, H3, H5, THD), wherein there is provision for a recognition unit (E), which is configured to detect preplanned disconnections (A) of the energy supply device, and wherein there is provision for a flagging unit (K), which is configured to explicitly flag parameters (U_{RMS}, f, H3, H5, THD) detected over the duration of the disconnections (A),
**characterised by**
an evaluation stage (W), which is configured to exclude the explicitly flagged parameters (U_{RMS}, f, H3, H5, THD) during the determination of the quality of the voltage (U) and/or current of the energy supply device.

9. Arrangement (7) according to claim 8,
**characterised in that**
in the case of an energy supply device having an isolator (3) the detection unit (E) is connected to the isolator (3).

10. Arrangement (7) according to one of claims 8 or 9,
**characterised in that**
a threshold value stage (G) is connected upstream of the flagging unit (K), which threshold value stage (G) is configured to identify threshold value violations of the voltage (U) and/or current of the energy supply device in the case of preplanned disconnections (A), and to issue a control signal to the flagging unit (K) if a threshold value violation having a duration exceeding a predefined time period is present.

11. Arrangement (7) according to claim 10,
**characterised in that**
the predefined time period amounts to at least one hour, preferably at least two hours, and particularly preferably at least five hours.

12. Arrangement (7) according to one of claims 10 or 11,
**characterised in that**
in the case of an energy supply device having a nominal voltage the threshold value violations of the voltage (U) are detected in the event of the nominal voltage being undershot by more than 95%, in particular more than 99%.

## Revendications

1. Procédé de détermination de la qualité de la tension (U) et/ou du courant d'un dispositif d'alimentation en énergie, dans lequel on détecte continuellement des paramètres de la tension (U_{EFF}, f, H3, H5, GHV) et/ou du courant et, à partir des paramètres (U_{EFF}, f, H3, H5, GHV) détectés, on détermine la qualité de la tension et/ou du courant, et dans lequel on détecte des déconnexions (A) prévues à l'avance du dispositif d'alimentation d'énergie et, pendant la durée des déconnexions, on caractérise particulièrement des paramètres (U_{EFF}, f, H3, H5, GHV) détectés,
**caractérisé en ce que**
les paramètres (U_{EFF}, f, H3, H5, GHV) caractérisés particulièrement reste non pris en compte dans la détermination de la qualité de la tension et/ou du courant du dispositif d'alimentation en énergie.

2. Procédé suivant la revendication 1,
**caractérisé en ce que**
pour un dispositif d'alimentation en énergie ayant un sectionneur (3), on détecte les déconnexions (A) prévues à l'avance au moyen d'une détection de la position du sectionneur (3).

3. Procédé suivant la revendication 2,
**caractérisé en ce que**
la durée des déconnexions (A) prévues à l'avance se déduit du temps entre un instant (t₁) de début et un instant (t₂) de fin, l'instant (t₁) de début étant l'instant de l'ouverture du sectionneur (3) moins un laps (a) de temps de tolérance et l'instant (t₂) de fin l'instant de la fermeture du sectionneur (3) plus le laps (a) de temps de tolérance.

4. Procédé suivant l'une des revendications précédentes,
**caractérisé en ce que**
pour détecter les déconnexions (A) prévues à l'avance, on détecte des atteintes à la valeur limite de la tension (U) et/ou du courant du dispositif d'alimentation en énergie et pour une durée, dépassant une durée donnée à l'avance, de l'atteinte à la valeur limite, on caractérise les paramètres (U_{EFF}, f, H3, H5, GHV) détectés.

5. Procédé suivant la revendication 4,
**caractérisé en ce que**
la durée donnée à l'avance est d'au moins une heure, de préférence d'au moins deux heures et d'une manière particulièrement préférée d'au moins cinq heures.

6. Procédé suivant la revendication 4 ou 5,
**caractérisé en ce que**
dans un dispositif d'alimentation en énergie ayant une tension de consigne, on détecte les atteintes à une valeur limite de la tension (U) lorsque l'on passe en dessous de la tension de consigne de plus de 95%, notamment de plus de 99%.

7. Procédé suivant l'une des revendications précédentes,
**caractérisé en ce que**
la caractérisation des paramètres (U_{EFF}, f, H3, H5, GHV) détectés s'effectue directement dans les données de mesure enregistrées au moyen d'un complément déchiffrable par ordinateur.

8. Système (7) de détermination de la qualité de la tension (U) et/ou du courant d'un dispositif d'alimentation en énergie, l'agencement (7) étant agencé pour détecter continuellement des paramètres de la tension (U_{EFF}, f, H3, H5, GHV) et/ou du courant et, à partir des paramètres (U_{EFF}, f, H3, H5, GHV) détectés, déterminer la qualité de la tension (U) et/ou du courant,
il est prévue une unité (E) de détection, qui est agencée pour détecter des déconnexions (A) prévues à l'avance du dispositif d'alimentation en énergie et dans lequel une unité (K) de caractérisation est prévue pour caractériser particulièrement des paramètres (U_{EFF}, f, H3, H5, GHV) détectés pendant la durée des déconnexions (A),
**caractérisé par**
un étage (W) d'exploitation, qui est agencé pour exclure les paramètres (U_{EFF}, f, H3, H5, GHV) caractérisés particulièrement lors de la détermination de la qualité de la tension (U) et/ou du courant du dispositif d'alimentation en énergie électrique.

9. Agencement (7) suivant la revendication 8,
**caractérisé en ce que**
pour un dispositif d'alimentation en énergie ayant un sectionneur (3), l'unité (E) de détection est en liaison avec le sectionneur (3).

10. Agencement (7) suivant l'une des revendications 8 ou 9,
**caractérisé en ce que**
en amont de l'unité (K) de caractérisation, est monté un étage (G) de valeur limite, qui est agencé pour constater, pour des déconnexions (A) prévues à l'avance, des atteintes à la valeur limite de la tension (U) et/ou du courant du dispositif d'alimentation en énergie et, s'il se produit une atteinte à la valeur limite d'une durée dépassant une durée donnée à l'avance, émettre un signal de commande vers l'unité (K) de caractérisation.

11. Agencement (7) suivant la revendication 10,
**caractérisé en ce que**
la durée donnée à l'avance est d'au moins une heure, de préférence d'au moins deux heures et d'une manière particulièrement préférée d'au moins cinq heures.

12. Agencement (7) suivant l'une des revendications 10 ou 11,
**caractérisé en ce que**
dans un dispositif d'alimentation en énergie ayant une tension de consigne, on détecte les atteintes à une valeur limite de la tension (U) lorsque l'on passe en dessous de la tension de consigne de plus de 95%, notamment de plus de 99%.
